# EUROPEAN PATENT APPLICATION

(11) **EP 2 546 870 A2**
(43) Date of publication of application: **16.01.2013**
(21) Application number: 11753594.8
(22) Date of filing: 09.03.2011
(51) Int. Cl.: H01L 23/15

(54) **METAL-BONDED CERAMIC SUBSTRATE**

(30) Priority: 09.03.2010 KR 20100020879
(71) Applicant: KCC Corporation, Seoul 137-070 (KR)
(72) Inventor: KIM, Kyong Hwan, Wanju-gun Jeollabuk-do 565-902 (KR); HAN, Moon Su, Wanju-gun Jeollabuk-do 565-902 (KR); PARK, Jun Hee, Wanju-gun Jeollabuk-do 565-902 (KR)
(74) Representative: Vossius & Partner
(86) International application number: PCT/KR2011/001609
(87) International publication number: WO 2011/111989

(57) **Abstract**

A metal-bonding ceramic substrate is provided. The ceramic substrate has a circuit pattern formed by bonding a metal layer on a surface thereof. A plurality of metal layers are disposed in rows and columns to form the circuit pattern. An additional metal layer is formed along an edge of at least one surface of the ceramic substrate to be disposed at the edge of the metal layer. In addition, the distance between the metal layers may be the same as that between the metal layer and the additional metal layer. Accordingly, dimension precision may be improved by reducing a variation of a circuit pattern in an etching process for forming a circuit, a bonding property of a semiconductor chip may be enhanced by reducing a temperature variation in thermal treatment of a lead ash layer for mounding the semiconductor chip, and bending of a substrate occurring due to a difference in the coefficient of thermal expansion between a metal and a ceramic may be reduced or artificially controlled.

## Description

### [Technical Field]

The present invention relates to a ceramic substrate, and more particularly, to a metal-bonding ceramic substrate having a structure that can improve precision of a circuit pattern in manufacture, productivity in a process of mounting a semiconductor diode, and process efficiency.

### [Background Art]

Conventionally, a metal-bonding ceramic substrate in which a metal such as copper (Cu) or aluminum (A1) is bonded to a substrate formed of a ceramic material such as alumina (Al₂O₃), aluminum nitride (AlN), silicon carbide (SiC) or silicon nitride (Si₃N₄) has been widely supplied and used as a component of a semiconductor device.

As a method of bonding a ceramic substrate and a metal circuit board into one, a direct bonding copper (DBC) method including contact-disposing a metal such as copper to a ceramic substrate, and heating the substrate at a temperature lower than the melting point (1083 °C) of copper and higher than the co-melting point (1065 °C) of copper and oxygen to directly bond the copper plate to the substrate was developed on a commercial scale. Recently, a ceramic circuit board, manufactured by an active metal method of bonding a metal circuit board using a lead ash layer to maintain higher heat emission and a high mechanical bonding property, was also developed and thus applied to power semiconductors requiring high reliability.

In recent years, the metal-bonding ceramic substrate is attained by bonding a metal plate to a large-scale ceramic substrate and forming a desired circuit pattern by a method of chemically etching a metal, which is a general pattern-forming method for a printed circuit board. According to such a method, circuit boards having several arrangements may be manufactured at the same time and finally cut into discrete products by a laser process using carbon dioxide before use.

Among the cut discrete circuit boards, however, one disposed on the edge has a different pattern dimension from the ones disposed in the central region, and is thermally treated after a lead ash layer is printed depending on the discrete products so as to mount a semiconductor diode. Here, it is difficult to meet a suitable temperature condition, compared with an untreated discrete circuit board. In addition, due to the difference in the effective area between the upper and lower patterns, the metal-bonding ceramic substrate may be bent, and thus is difficult to apply to an automation process.

### [Disclosure]

### [Technical Problem]

The present invention is directed to providing a metal-bonding ceramic substrate having a composite arrangement structure which is effective in improving dimension precision in an etching process for forming a circuit pattern and facilitating better bending and higher strength, which are preferable in printing a lead ash layer to mount a semiconductor diode, thereby performing a stable process and maintaining a uniform temperature in thermal treatment of the lead ash layer.

The objects of this present invention is aiming for are not limited to that described above. The present invention, however, may include other objects that are not described herein but will be clearly understood by one of ordinary skill in the art from the following detailed description.

### [Technical Solution]

In one aspect, a metal-bonding ceramic substrate has a circuit pattern formed by bonding a metal layer on a surface thereof, and a plurality of metal layers are disposed in rows and columns. An additional metal layer is formed along the edge of at least one surface of the ceramic substrate to be disposed on the outside of the metal layer.

The distance between the metal layers may be the same as that of the distance between the outermost metal layer and the additional metal layer.

At least one cutting line may be formed between the metal layers and the metal layer and the additional metal layer.

The cutting line may be composed of an external cutting line formed at the edge of the metal layer and an internal cutting line formed between the metal layers.

The additional metal layer may have a cutting channel formed at a part corresponding to an extension of a boundary of the metal layers, which are plural in number and disposed in rows and columns.

The internal cutting line may extend only to an edge of the metal layer, and the external cutting line may extend to the edge of the ceramic substrate through the cutting channel.

The external and internal cutting lines may extend to the edge of the ceramic substrate through the cutting channel.

The ceramic substrate may be formed of a ceramic material such as alumina (Al₂O₃), aluminum nitride (AlN), silicon carbide (SiC) or silicon nitride (Si₃N₄), and the metal layer may be formed of copper or aluminum.

The additional metal layer may be formed on the upper and lower surfaces of the ceramic substrate to have different areas and shapes.

### [Advantageous Effects]

According to the present invention, the dimension precision can be improved by reducing the variation of a circuit pattern in an etching process for forming a circuit, the bonding property of a semiconductor chip can be enhanced by reducing the temperature variation in a thermal treatment of a lead ash layer for mounding a semiconductor chip, and bending of a substrate occurring due to a difference in the coefficient of thermal expansion between a metal and a ceramic can be reduced or artificially controlled.

### [Description of Drawing]

FIGS. 1A to 1F are schematic views illustrating the process of manufacturing a metal-bonding ceramic substrate.
FIG. 2 is a plan view of a conventional metal-bonding ceramic substrate.
FIG. 3 is a plan view of a metal-bonding ceramic substrate according to an exemplary embodiment of the present invention.
FIG. 4 is an enlarged view of parts drawn by dotted lines in FIGS. 2 and 3.
FIG. 5 is a graph schematically showing the temperature distribution in thermal treatment of the conventional metal-bonding ceramic substrate.
FIG. 6 is a graph schematically showing the temperature distribution in thermal treatment of the metal-bonding ceramic substrate according to the exemplary embodiment of the present invention.
FIG. 7 is an X-ray image after thermal treatment of a lead ash layer on a metal-bonding ceramic substrate.
FIG. 8 is a graph schematically showing the stress distribution on the upper and lower surfaces of the conventional metal-bonding ceramic substrate.
FIG. 9 is a schematic view of a conventional metal-bonding ceramic substrate that is bent.
FIG. 10 is a plan view of a metal-bonding ceramic substrate according to another exemplary embodiment of the present invention.
FIG. 11 is a plan view of a metal-bonding ceramic substrate according to still another exemplary embodiment of the present invention.

### [Best Mode]

Hereinafter, an exemplary embodiment of a metal-bonding ceramic substrate according to the present invention will be described in detail with respect to the accompanying drawings.

Before describing, the configuration denoted by reference numeral 10 is expressed as both terms, for example, a ceramic substrate and a metal-bonding ceramic substrate, and the configuration denoted by reference numeral 20 is expressed as both terms, for example, a metal or a metal layer.

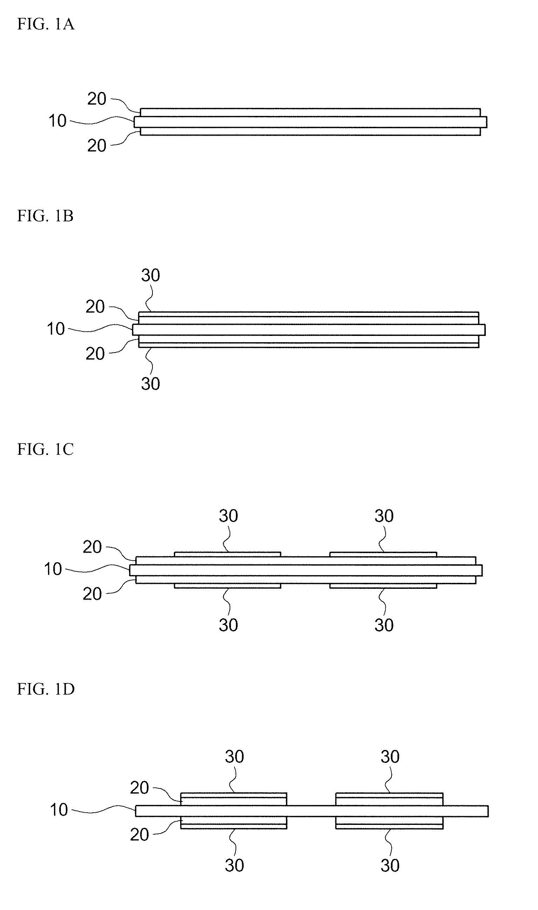

First, the process of manufacturing a metal-bonding ceramic substrate will be described with reference to FIGS. 1A to 1F. According to the general process of manufacturing a metal-bonding ceramic substrate, a metal 20 is contact-disposed on a ceramic substrate 10, they are bonded together by a DBC or active metal method as shown in FIG. 1A, and the metal-bonding ceramic substrate 10, manufactured by such bonding, is coated with a photosensitive film 30, which is a dry film, to cure a desired part by UV exposure (See FIG. 1B).

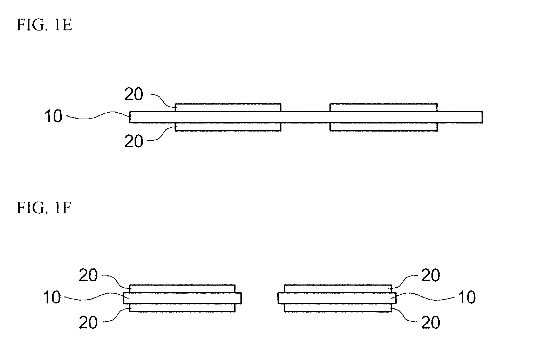

Subsequently, an uncured part of the metal layer 20 formed by bonding to the ceramic substrate 10 is developed as shown in FIG. 1C, and a circuit pattern is formed on the ceramic substrate 10 through an etching process for removing an unnecessary part by an acid chemical (See FIG. 1D). In addition, the photosensitive film 30 is removed by a peeling process (See FIG. 1E), and finally, the circuit pattern is formed using the metal layer 20 bonded to the ceramic substrate 10 through an etching process.

Lastly, the circuit pattern is uniformly disposed on the ceramic substrate 10 and is cut into pieces by melting the ceramic using a carbon dioxide laser generating strong photoenergy (See FIG. 1F). The metal-bonding ceramic substrate 10 manufactured according to the manufacturing method described above may be designed in various arrangements according to the designing methods by manufacturers or requests by consumers.

For example, circuit patterns may be symmetrically formed by bonding the metal layers 20 to both surfaces of the ceramic substrate 10, or a circuit pattern is formed on one surface of the ceramic substrate 10 and the metal layer 20, not a circuit pattern, may be formed entirely on the other surface of the ceramic substrate 10.

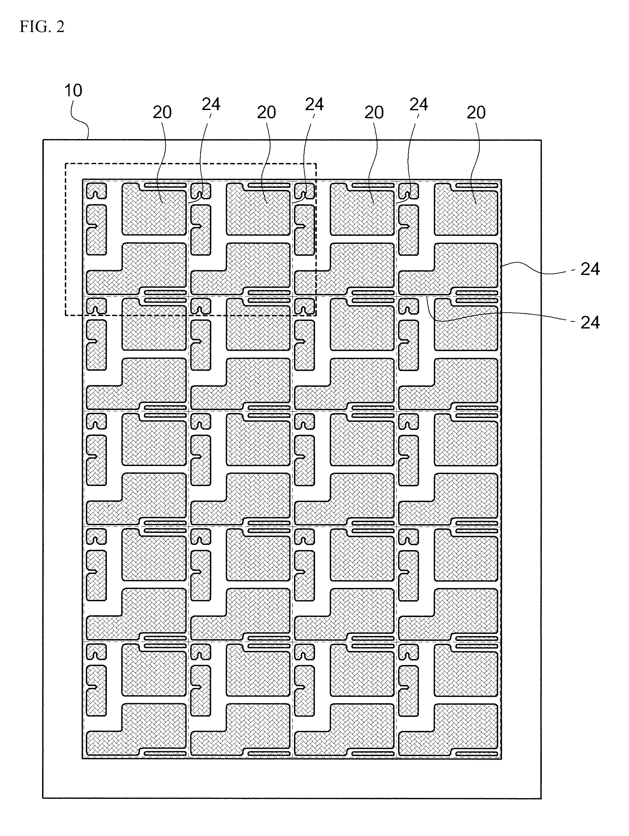

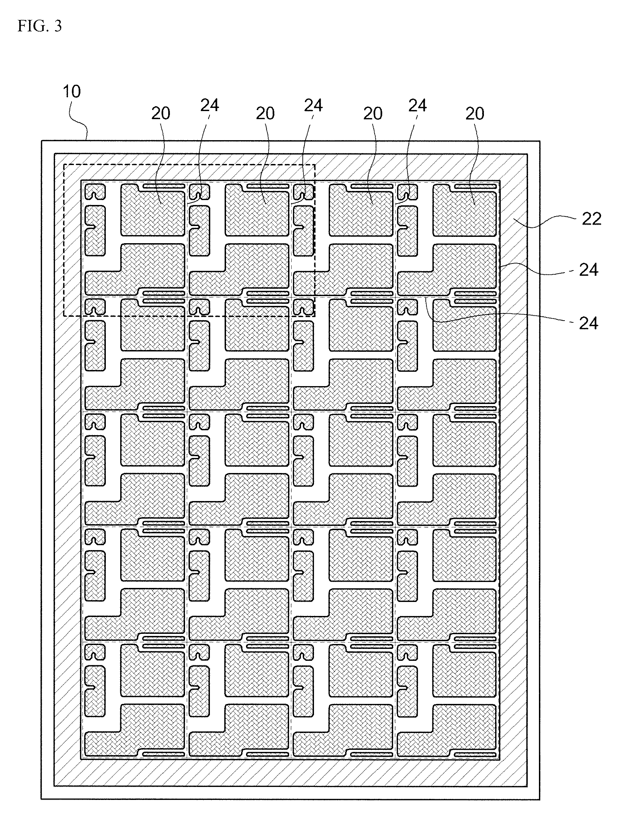

Next, FIG. 2 is a plan view of a conventional metal-bonding ceramic substrate, and FIG. 3 is a plan view of a metal-bonding ceramic substrate according to an exemplary embodiment of the present invention.

Referring to FIGS. 2 and 3, the conventional metal-bonding ceramic substrate is compared with the metal-bonding ceramic substrate according to the present invention. In a prior art, the plurality of metal layers 20 may be disposed in rows and columns on one surface of a ceramic substrate 10. Here, all the metal layers 20 having no circuit pattern formed therein are removed. That is, unnecessary parts which are on the edge of the metal layer 20 are all removed. However, referring to FIG. 3, an additional metal layer 22 is bonded to the outside of the metal layer 20 in the metal-bonding ceramic substrate according to the present invention.

The ceramic substrate 10 and the metal layer 20 may be formed of various materials. For example, the ceramic substrate 10 may be formed of a ceramic material such as alumina (Al₂O₃), aluminum nitride (AlN), silicon carbide (SiC) or silicon nitride (Si₃N₄), and the metal layer 20 is formed of copper (Cu) or aluminum (Al).

The additional metal layer 22 may be formed along an edge of the ceramic substrate 10 by bonding to at least one surface of the ceramic substrate 10. The additional metal layer 22 surrounds the edge of the metal layer 20 in a strap shape. The additional metal layer 22 formed as described above can improve dimension precision of the ceramic substrate 10 and can improve the bonding property of a semiconductor chip by reducing the temperature variation in thermal treatment. Detailed descriptions about these characteristics will be provided below.

Meanwhile, the cutting line 24 is formed between the metal layers 20. In addition, the cutting line 24 is also formed between the metal layer 20 and the additional metal layer 22. The cutting line 24 is a part formed to facilitate cutting the metal layer 20.

In the exemplary embodiment of the present invention, to improve the dimension precision of the ceramic substrate 10, the distance between the metal layers 20 may be the same as the distance between the outermost metal layer 20 and the additional metal layer 22. In addition, the cutting line 24 is formed at a central region between the metal layers 20, and the central region between the outermost metal layer 20 and the additional metal layer 22.

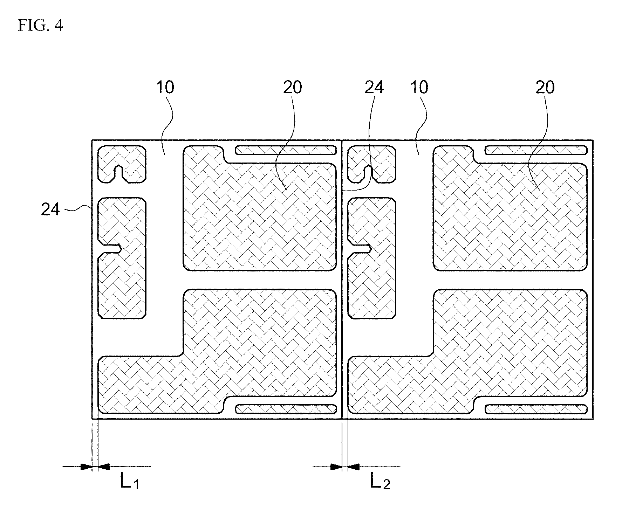

FIG. 4 is an enlarged view of parts drawn by dotted lines in FIGS. 2 and 3.

Referring to FIG. 4, it is assumed that the distance between the outermost metal layer 20 and the cutting line 24 refers to dimension 1 (L1), and the distance between the inner metal layer 20 and the cutting line 24 refers to dimension 2 (L2).

Since the precision of a circuit pattern is a very important factor in the metal-bonding ceramic substrate 10, in the past, the shape of the circuit pattern was pressed using a mold and was directly bonded to a single substrate. However, in recent years, as described in FIG. 1, the desired circuit pattern is left intact using an etching process, but unnecessary parts are removed by a chemical reaction. Here, since the conventional metal-bonding ceramic substrate 10 does not have an additional metal layer 22 formed on the edge thereof (in FIG. 2), etching progressed on the edge more rapidly than in the central region (a part having the metal layer), and thus dimension 1 was always larger than dimension 2.

However, since the metal-bonding ceramic substrate 10 according to the present invention has the additional metal layer 22 formed on the edge thereof (in FIG. 3), etching may progress under the same condition as in the central region (the part having the metal layer). Accordingly, dimension 1 and dimension 2 may be the same as each other in the metal-bonding ceramic substrate 10 according to the present invention, and thus the dimension precision of the circuit pattern may be enhanced.

Table 1 shows circuit dimensions of metal-bonding ceramic substrates. While in the conventional metal-bonding ceramic substrate, dimension 1 is approximately 0.1 mm larger than dimension 2 and in the present invention dimension 1 is almost the same as dimension 2. This is because the conventional metal-bonding ceramic substrate is different from the metal-bonding ceramic substrate according to the present invention in that the same environments are not provided to the adjacent regions in etching the metal layer 20 in the case of the conventional metal-bonding ceramic substrate, but the metal layers 20 are disposed at the same distance from the adjacent regions in the case of the metal-bonding ceramic substrate according to the present invention.

**[Table 1]**

| No. | Conventional | | Inventive | |
|---|---|---|---|---|
| | Dimension 1 | Dimension 2 | Dimension 1 | Dimension 2 |
| Set Value | 0.6 | 0.6 | 0.6 | 0.6 |
| I | 0.702 | 0.613 | 0.608 | 0.611 |
| 2 | 0.712 | 0.610 | 0.604 | 0.608 |
| 3 | 0.708 | 0.621 | 0.602 | 0.620 |
| 4 | 0.692 | 0.619 | 0.609 | 0.622 |
| 5 | 0.699 | 0.601 | 0.611 | 0.601 |
| 6 | 0.705 | 0.602 | 0.622 | 0.598 |
| 7 | 0.712 | 0.605 | 0.611 | 0.621 |
| 8 | 0.705 | 0.607 | 0.617 | 0.609 |
| 9 | 0.704 | 0.611 | 0.611 | 0.611 |
| 10 | 0.698 | 0.605 | 0.608 | 0.624 |
| Average | 0.704 | 0.609 | 0.610 | 0.613 |

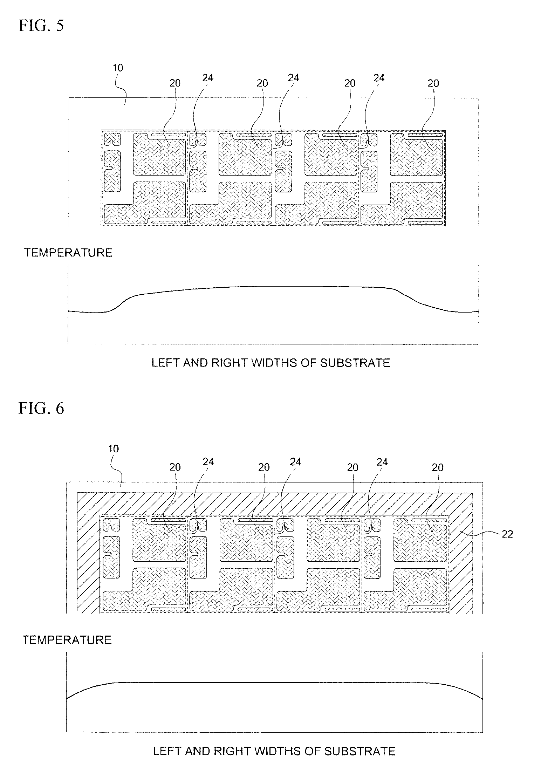

Subsequently, FIG. 5 is a graph schematically showing the temperature distribution in thermal treatment of the conventional metal-bonding ceramic substrate, and FIG. 6 is a graph schematically showing the temperature distribution in thermal treatment of the metal-bonding ceramic substrate according to the exemplary embodiment of the present invention.

Referring to FIGS. 5 and 6, to mount a semiconductor chip on the metal-bonding ceramic substrate, a lead ash layer is formed on the surface of the ceramic substrate using a printing method, a semiconductor chip is disposed on the lead ash layer, and they are then bonded to each other. Here, the semiconductor chip may be strongly bonded to the ceramic substrate 10 when the lead ash layer melts in continuous thermal treatment equipment in which the temperature is maintained at 150 to 350 °C for approximately 10 to 30 min.

Here, depending on the variation of the temperature applied to the ceramic substrate 10 in the thermal treatment, there is a difference in the melting degree of the lead ash layer. When there is a wide temperature variation, the lead ash layer does not melt, so that the bonding between the ceramic substrate and the semiconductor chip may not be properly executed, and when excessive heat is concentrated on the ceramic substrate 10, a void may be generated in the ceramic substrate 10 due to the spreading of the lead ash layer so that a bonding property decreases.

Referring to FIG. 5, since the additional metal layer 22 is not formed on the edge of the conventional metal-bonding ceramic substrate, there may be a difference in temperature distribution in a single substrate so that the bonding property of the lead ash layer decreases in the thermal treatment as described above.

However, referring to FIG. 6, since the additional metal layer 22 is formed on the edge of the metal-bonding ceramic substrate according to the present invention, the temperature is relatively uniformly distributed in a width direction of the ceramic substrate 10. Therefore, the lead ash layer melts uniformly in the thermal treatment, and thus the bonding property of the lead ash layer may be enhanced, and thermal treatment characteristics may be improved.

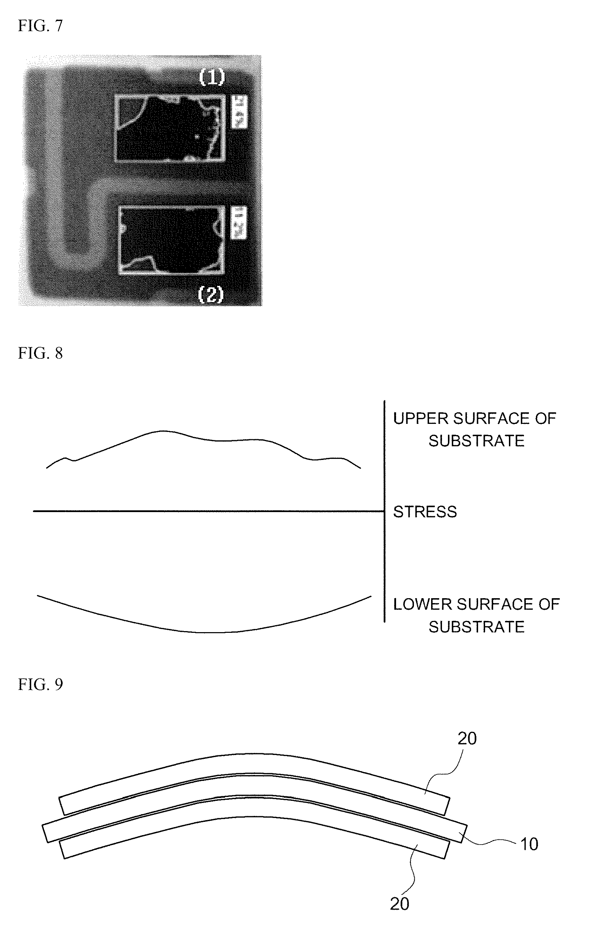

Referring to FIG. 7, the actual area of the bonded lead ash layer when there is a difference in temperature distribution according to the conventional art is imaged using X-rays. It can be confirmed that there are unbonded parts and internal voids.

Table 2 shows wettability of the lead ash layer in location (1) and location (2) shown in FIG. 7. Referring to Table 2, in the conventional art, the difference between location (1) (edge) and location (2) (central region) is approximately 10%, which considerably reduces the bonding property with the semiconductor chip and adversely affects selection of the process condition. However, in the present invention, the difference between location (1) and location (2) is approximately less than 1%, and average wettabiltiy is less than 5%, so that the wettaiblity is considerably improved compared to the conventional art.

**[Table 2]**

| No. | Conventional | | Inventive | |
|---|---|---|---|---|
| | Location 1 | Location 2 | Location 1 | Location 2 |
| 1 | 21.4% | 11.2% | 4.2% | 3.8% |
| 2 | 18.5% | 8.0% | 3.6% | 3.4% |
| 3 | 19.5% | 8.8% | | 5.4% 3.9% |
| 4 | 21.2% | 5.5% | 4.8% | 3.8% |
| 5 | 18.8% | 9.8% | 4.2% | 3.2% |
| 6 | 17.5% | 8.5% | 4.8% | 3.6% |
| 7 | 19.2% | 7.6% | 5.5% | 3.7% |
| 8 | 20.1% | 9.8% | 4.5% | 3.5% |
| 9 | 20.5% | 10.2% | 3.8% | 3.7% |
| 10 | 22.6% | 8.4% | 4.1% | 3.8% |
| Average | 19.93% | 8.78% | 4.49% | 3.64% |

Next, FIG. 8 is a graph schematically showing the stress distribution on the upper and lower surfaces of the conventional metal-bonding ceramic substrate, and FIG. 9 is a schematic view of the conventional metal-bonding ceramic substrate which is bent.

Generally, a semiconductor diode is mounted on the upper surface of the metal-bonding ceramic substrate, and various types of circuit patterns for connecting a circuit to a circuit and a circuit to a semiconductor diode through wire bonding are realized. On the other hand, a simple rectangular pattern, not a complicated pattern, is formed on the lower surface of the metal-bonding ceramic substrate to effectively radiate heat to a part bonded with the radiator.

Referring to FIG. 8, the stress distribution is differently shown on the upper and lower surfaces of the conventional metal-bonding ceramic substrate due to a large difference in the coefficient of the thermal expansion between copper (approximately 16.7 x 10⁻⁶/°C) and ceramic (AIN: 4.6x10⁻⁶/°C, Alumina: 6.8x10⁻⁶/°C). That is, it can be seen that stress is relieved on the upper surface having various circuit patterns, and large stress is generated on the entire lower surface since there is no disconnection of the circuit pattern.

The conventional metal-bonding ceramic substrate is bent by the stress distribution as shown in FIG. 9. In the present invention, to minimize bending, the additional metal layer 22 is further formed as described above. As the additional metal layer 22 that is formed as described above has various areas and shapes, the ceramic substrate may be bent less, and the bending of the ceramic substrate may be controlled in a desired direction.

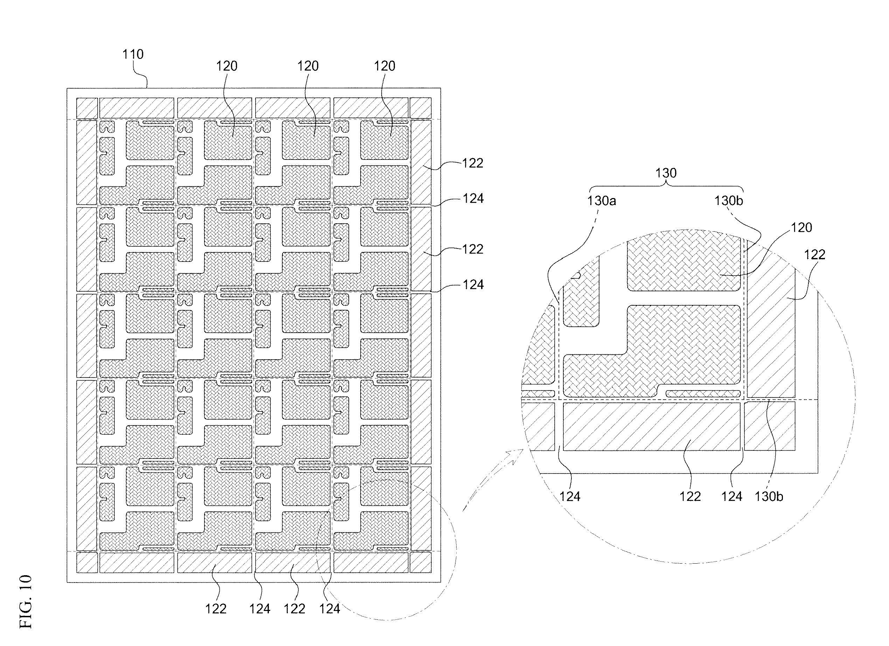

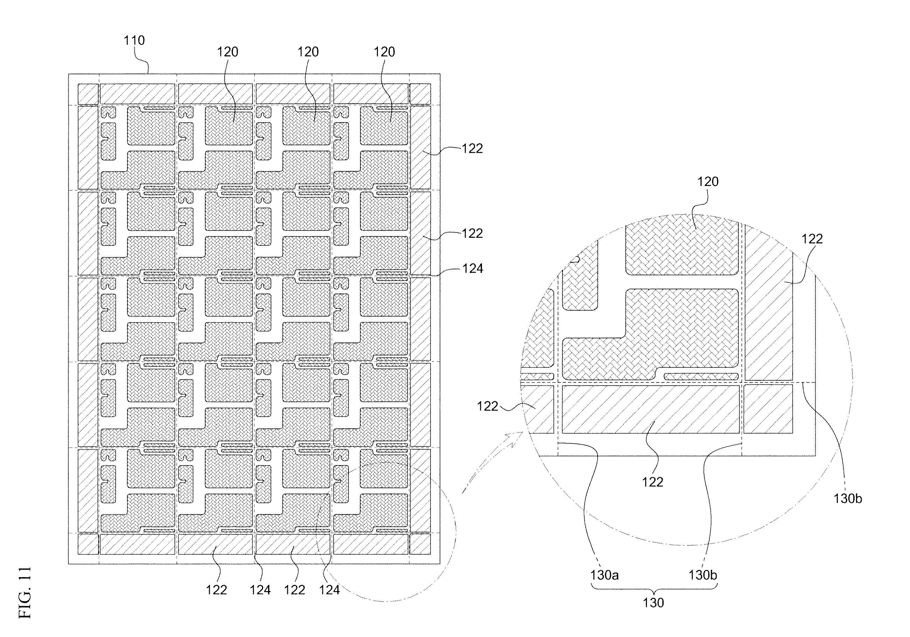

Meanwhile, FIG. 10 is a plan view of a metal-bonding ceramic substrate according to another exemplary embodiment of the present invention, and FIG. 11 is a plan view of a metal-bonding ceramic substrate according to still another exemplary embodiment of the present invention. In the drawings, the same components as in the exemplary embodiment described above are denoted by reference numerals of hundreds, and detailed descriptions thereof will be omitted.

First, referring to FIG. 10, unlike the exemplary embodiment described above, additional metal layers 122 are not connected by means of one strap, and the cutting channel 124 is formed between the additional metal layers 122. The cutting channel 124 is a part corresponding to the extension of a boundary between metal layers 120.

The cutting line 130 is composed of an internal cutting line 130a and an external cutting line 130b. The external cutting line 130b is a cutting line disposed at the edge (the outermost layer) of a plurality of the metal layers 120 disposed in rows and columns, and the internal cutting line 130a is a cutting line formed between the metal layers 122 as a cutting line disposed inside.

In the exemplary embodiment illustrated in FIG. 10, the internal cutting line 130a does not extend to the cutting channel 124, but the external cutting line 130 extends to the cutting channel 124. Here, the entire external cutting line 130b may not extend to the cutting channels 124, but only parts corresponding to both ends (upper and lower ends or left and right ends in FIG. 10) of the external cutting line 130b extend to the cutting channels 124. That is, at least parts of the external cutting line 130b extend to the cutting channels 124. It is to cut first the parts corresponding to both ends of the external cutting line 130b when the additional metal layer 22 is cut, and to prevent random cutting of the additional metal layer 122 perpendicularly disposed from the metal layer 120 after the external cutting line 130b is cut.

Subsequently, in the exemplary embodiment illustrated in FIG. 11, all of the external and internal cutting lines 130b and 130b extend to an edge of a ceramic substrate 110 through a cutting channel 124.

While the invention has been shown and described with reference to certain exemplary embodiments thereof, it will be understood by those skilled in the art that various changes in form and details may be made therein without departing from the scope of the invention as defined by the appended claims.

## Claims

1. A metal-bonding ceramic substrate, comprising a metal layer bonded on the surface thereof to form a circuit pattern, the metal layer being plural in number and disposed in rows and columns,
wherein an additional metal layer is formed along an edge of at least one surface of the ceramic substrate to be disposed on the outside of the metal layer.

2. The metal-bonding ceramic substrate according to Claim 1, wherein the distance between metal layers is the same as that between the outermost metal layer and the additional metal layer.

3. The metal-bonding ceramic substrate according to Claim 1, wherein at least one cutting line is formed between the metal layers and between the metal layer and the additional metal layer.

4. The metal-bonding ceramic substrate according to Claim 3, wherein the cutting line is comprising an external cutting line formed at the edge of the metal layer and an internal cutting line formed between the metal layers.

5. The metal-bonding ceramic substrate according to Claim 4, wherein the additional metal layer has a cutting channel formed at a part corresponding to the extension of the boundary of the metal layers, which are plural in number and disposed in rows and columns.

6. The metal-bonding ceramic substrate according to Claim 5, wherein the internal cutting line extends only to the edge of the metal layer, and the external cutting line extends to the edge of the ceramic substrate through the cutting channel.

7. The metal-bonding ceramic substrate according to Claim 5, wherein the external and internal cutting lines extend to the edge of the ceramic substrate through the cutting channel.

8. The metal-bonding ceramic substrate according to Claim 1, wherein the ceramic substrate is formed of a ceramic material such as alumina (Al₂O₃), aluminum nitride (AlN), silicon carbide (SiC) or silicon nitride (Si₃N₄), and the metal layer is formed of copper or aluminum.

9. The metal-bonding ceramic substrate according to Claim 1, wherein the additional metal layer is formed on upper and lower surfaces of the ceramic substrate to have different areas and shapes.
